# EUROPEAN PATENT APPLICATION

(11) **EP 2 819 348 A1**
(43) Date of publication of application: **31.12.2014**
(21) Application number: 11860022.0
(22) Date of filing: 14.12.2011
(51) Int. Cl.: H04L 12/28

(54) **NETWORK SIMULATION STRUCTURE AND SIMULATION METHOD THEREOF**

(30) Priority: 01.03.2011 CN 201110049679; 28.09.2011 CN 201110301687
(71) Applicant: Lin, Dingwei, Guangzhou, Guangdong 510600 (CN)
(72) Inventor: Lin, Dingwei, Guangzhou, Guangdong 510600 (CN)
(74) Representative: Isern-Jara, Nuria
(86) International application number: PCT/CN2011/083964
(87) International publication number: WO 2012/116567

(57) **Abstract**

Disclosed are a network simulation structure and a simulation method thereof. The structure includes a plurality of nodes and arcs, wherein the nodes are connected with each other via the arcs, the arcs are provided with switches that control the connection/disconnection of the arcs, so as to change the topology of the network. In this disclosure, a plurality of topologies can be realized on one type of network model, and at the same time, a plurality of logic operation methods can also be realized, improving the speed and efficiency of operation.

## Description

### FIELD OF THE INVENTION

The present invention relates to the technology of network topology, and more particularly to a network simulation structure and the simulation method thereof.

### BACKGROUND OF THE INVENTION

In prior art of network technology, computer application technologies are usually used to construct particular mathematical model to simulate the network structure of an entity; then an application algorithm of this mathematical model is proposed. That is, whenever simulating the network structure of an entity, people have to re- construct a corresponding mathematical model using computer application technology, of which the whole process is very complicated. In addition, people usually use the complicated exhaustion test algorithm in the application algorithms of existing large mathematical models to find solution, that's why the world reward question "P = NP" in mathematical field has no solution yet. Therefore, by the simulation methods of prior art, various types of networks and models cannot be easily stimulated or constructed, nor can the interchange of various topologies be achieved, not to mention efficient application of the models.

### SUMMARY OF THE INVENTION

An object of the present invention is to overcome the drawbacks and shortcomings of the prior art by providing a network stimulation structure to achieve a variety of topologies as well as a variety of operation methods, so as to improve the speed and efficiency of operation.

It is another object of the present invention to provide a network stimulation method.

To achieve the above object, this invention adopts the following technical solutions:
a network stimulation structure includes a plurality of nodes and arcs, wherein the nodes are connected with each other via the arcs, and the arcs are provided with switches.

Preferably, the switches are circuit switches or optical circuit switches.

To achieve another object, the present invention adopts the following technical solutions:
A network simulation method, comprising the following steps:
   (1) setting a plurality of nodes;
   (2) connecting the nodes by the arcs;
   (3) setting switches on the arcs to control the connection/disconnection of the arcs by turning the switches open/closed, so as to achieve a variety of network topologies.

Preferably, the nodes are connected end to end, forming a circular topology.

Preferably, by controlling the connection/ disconnection of the arcs, some of the nodes and arcs form a circular topology, whereas other nodes and arcs form a bus topology.

The present invention has the following advantages and effects compared to the prior art:
1. By the network structure formed by nodes and arcs of the present invention, it is possible to simulate various physical networks, so as to construct more efficient network models, thereby improving the operation efficiency.
2. By controlling the open/closed status of the switches and consequently the connection/disconnection of the arcs, a variety of topologies are achieved on one network model; various operation modes are also achieved, improving the speed and efficiency of operation.

### BRIEF DESCRIPTION OF THE DRAWINGS

Fig. 1 is a schematic drawing showing the network structure according to one embodiment of the present invention.
Fig. 2 is a schematic drawing showing the circuit of side AB of the network topology according to one embodiment of the present invention.
Fig. 3 is a schematic drawing showing the circuit of side CD of the network topology according to one embodiment of the present invention.

### DETAILED DESCRIPTION OF THE PREFERED EMBODIMENTS

The present invention will be further described in detail in the following with reference to the embodiments and the accompanying drawings. However, the implementing ways of the present invention are not limited to these thereof.

### Embodiment 1

A network simulation structure includes a plurality of nodes and arcs; each two nodes are connected with each other via an arc, and the arcs are connected with switches for controlling the connection/disconnection of the arcs, so as to change the topology of the network.

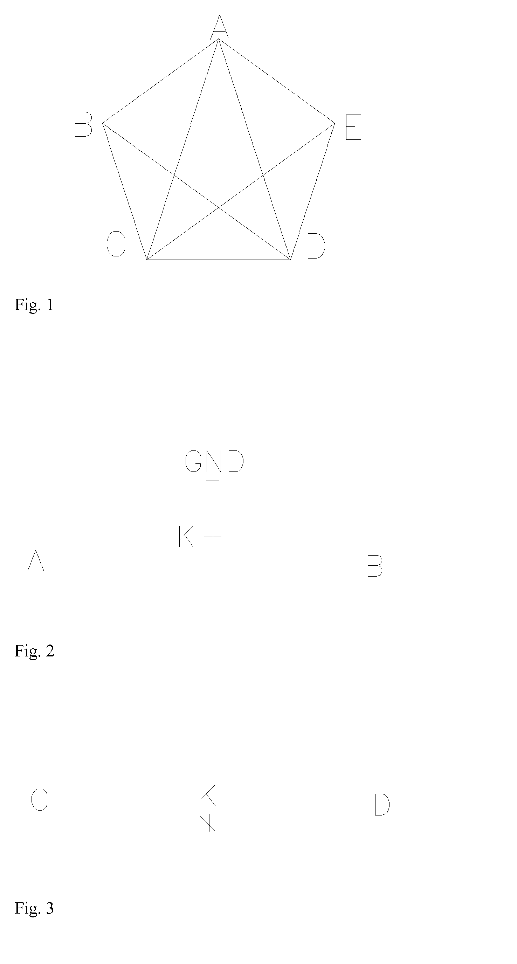

For example, in the circuit of side AB shown in Fig. 2, a switch K (for example, a contact) is provided between the circuit and the ground. When K is open, node A and B are connected. When K is closed, node A and B are disconnected. By this way controlling of connection/disconnection of each arc (side) is achieved.

### Embodiment 2

Take the optical circuit connection of side CD for example. As shown in Fig. 3, an optical switch K (for example, a repeater) is connected with the optical circuit of side CD. When K is closed, node C and D are connected; when K is open, node C and D are disconnected. By this way controlling of connection/disconnection of each arc (side) is achieved.

Based on the above network structure construction, stimulation of the status of physical networks can be realized, and various functions of specific circuits can be performed.

A network simulation method based on the above network stimulation structure, includes the following steps:
(1) setting a plurality of nodes;
(2) connecting the nodes by the arcs; and
(3) setting switches on the arcs to control the connection/disconnection of the arcs by turning the switches open/closed, so as to achieve a variety of network topologies.

Based on the above network model, a variety of logical operations can be realized, such as OR operation circuit. Take the circular loop formed by node A, B and E in Figure 1 for example. As long as Kab (the switch) between A and B is closed, the relationship between A and E will depend on the status of the switch Kbe between B and E and the switch Kae between A and E. Thus, an OR operation circuit determined by parameters of Kbe and Kae is formed between A and E.

As to AND operation circuit, as long as Kab (the switch) between A and B is open, then the relationship between A and B will depend on the status of the switch Kbe between B and E and the switch Kae between A and E. Thus, an AND operation circuit determined by parameters of Kbe and Kae is formed between A and B.

Similarly, by controlling the closed/open status of the switches, a variety of logical operations can be realized on one network model, so as to solve different problem s in practice.

Obviously, increasing operation parameters will not double the operation time by this method, which makes it possible to solve the question of "P=NP". In addition, no fixed operation core is necessarily needed; thus, a variety of operations can be performed at the same time in the operation device, thereby greatly enhancing the processing capacity of operation device.

Based on the above network model, various topologies can be achieved. When respective switches between AB, BC, CD, DE and EA are closed, whereas the switches on the other arcs are open, a circular topology is formed. Similarly, by controlling the connection/disconnection of the arcs, various topologies can be stimulated, such as bus topology, star topology, tree topology, net topology and cell topology.

In addition, various topologies can co-exist within one network model, which combines the advantages of different topologies. As shown in Fig. 1, when the switches of AC and AD are closed, a star topology is formed, and when AB, BE and AE are closed, a circular topology is formed. That is, two different topologies are formed within one model. Similarly, co-existing of a plurality of topologies can be achieved depending on practical need.

The above are the preferred embodiments of the present invention. However, the embodiments of the present invention are not limited to the above. Any variations, modifications, alternations, combinations and simplifications should be equivalents to the present invention, and are included within the scope of the present invention.

## Claims

1. A network simulation structure, comprising:
arcs, provided with switches; and
a plurality of nodes, connected with each other via the arcs.

2. The network simulation structure of claim 1, wherein the switches are circuit switches.

3. The network simulation structure of claim 1, wherein the switches are optical circuit switches.

4. A network simulation method based on the structure of claim 1, comprising the following steps:
(1) setting a plurality of nodes;
(2) connecting the nodes by arcs;
(3) setting switches on the arcs to control the connection/disconnection of the arcs by turning on/off the switches, so as to achieve a variety of network topologies.

5. The network simulation method of claim 4, wherein in the step (3), the nodes are connected to each other end to end, forming a circular topology.

6. The network simulation method of claim 4, wherein by controlling the connection/ disconnection of the arcs, some of the nodes and arcs form a circular topology, whereas other nodes and arcs form a bus topology.
